# EUROPEAN PATENT SPECIFICATION

(11) **EP 0 473 067 B1**
(45) Date of publication and mention of the grant of the patent: **03.01.1996**
(21) Application number: 91114081.2
(22) Date of filing: 22.08.1991
(51) Int. Cl.: C23C 16/44

(54) **Wafer processing reactor**
Reaktor zur Behandlung von Halbleiterscheiben.
Réacteur pour le traitement de plaquettes

(30) Priority: 23.08.1990 US 571957
(43) Date of publication of application: 04.03.1992
(60) Divisional application: 95106353.6
(73) Proprietor: APPLIED MATERIALS INC., Santa Clara California 95052 (US)
(72) Inventor: Anderson, Roger N., San Jose, CA 95124 (US); Lindstrom, Paul R., Aptos, CA 95003 (US); Johnson, Wayne, Phoenix, AZ 85044 (US)
(74) Representative: Kahler, Kurt, Dipl.-Ing.

(56) References cited:
- EP-A- 0 254 654
- WO-A-89/12703
- WO-A-90/07019
- PATENT ABSTRACTS OF JAPAN, vol. 5, no. 63 (E-54)(735) 28 April 1981

## Description

### Background of the Invention

This invention relates in general to wafer processing reactors and relates more particularly to the supply of reactant gases to reaction chambers of said wafer processing reactors.

To remain price competitve in integrated circuit fabrication it is important to increase continually the throughput of a wafer processing system. Batch processing systems have been used to increase throughput. However, in state of the art devices it is necessary to utilize single wafer processing systems to achieve the processing uniformity needed to achieve state of the art feature sizes. For equipment utilized to achieve state of the art linewidths it is particularly important to achieve as high a uniformity of processing across the wafer as possible.

As the feature size of integrated circuits shrinks and the size of wafers increases, it becomes increasingly important to accurately control the rates of various wafer processing steps to achieve process uniformity across the entire wafer. The uniformity obtained by all process steps, including all plasma processes and chemical vapor deposition processes, are affected by the distribution of process gases within the processing chamber. In many existing systems, process gases are injected into the processing chamber at a point that is remote from the wafer so that a uniform distribution of the gases is achieved before these gases reach the wafer. The wafer is typically located between the remote gas inlets and an exhaust port so that the reactant gases flow past the wafer. To further improve the uniformity of processing, many systems include the ability to rotate the wafer during processing to increase the uniformity of the time-averaged physical and chemical environment of the wafer during processing. However, to achieve improved process control it would be advantageous to have a greater degree of control over the distribution of gases within the reaction chamber than is now available.

WO 89/12703 discloses a wafer processing system comprising a reaction chamber, a slit-shaped gas inlet port for supllying process gases across a substrate in said chamber and a gas supply manifold consisting of mechanical means connected to a plurality of inlets into said inlet port to allow a changeable spatial gas flow distribution of said gas through said inlet part.

### Summary of the Invention

The afore mentioned objective is met by a wafer processing reactor as disclosed in claim 1. Preferred embodiments are disclosed in dependent claims 2 to 12.

In accordance with the illustrated preferred embodiment, a gas flow system is presented that enables accurate control of gas flow rates and composition across a wafer during processing, thereby enhancing the ability to control the distribution of wafer processing rates across the wafer. Although this gas flow system is applicable to batch processing systems, it is best implemented in single wafer processing systems. This gas flow system provides the process gases from a gas inlet port adjacent to the wafer(s) so that the flow rates and concentrations of the gases at the wafer can be more accurately controlled. Preferably, the gases are applied near the edge of the wafer at one side of the wafer and flow across the wafer to an exhaust port located diametrically opposite across the wafer from the gas inlet port. Preferably, the spacing between the gas inlet port and the nearest edge of the wafer as well as the spacing between the exhaust port and the nearest edge of the wafer are small so that there is a reduced amount of deadspace in the system and so that control of the distribution of gases across the wafer is enhanced. Thus, it is advantageous for the reactor to include a cylindrical section that closely surrounds the sides of the wafer. The inlet port and exhaust port can be located in this cylindrical section to enable them to inject and exhaust, respectively, gases at the wafer.

A gas supply manifold is attached to the gas inlet port to enable the gas composition and flow rate to be varied across the gas inlet port, thereby enabling control over the spatial distribution of gas composition and flow rates at the wafer surface. This gas supply manifold includes a set of gas injectors each of which is connected through flow controllers to associated gas sources. The gas inlet port is preferably in the shape of a thin slot that is parallel to the wafer so that this port supplies gases to the immediate vicinity of the edge of the wafer. The exhaust port is also preferably in the shape of a thin exit slit that is parallel to the wafer so that this port exhausts gases from the immediate vicinity of the edge of the wafer.

In the gas inlet port, a number of vertical vanes can be included to provide physical strengthening of the inlet port. In addition, these vanes can prevent mixing of injected gases from different inlet jets of the gas supply manifold until these gases reach points closer to the edge of the wafer than the distance of the gas injectors from the edge of the wafer. Each pair of adjacent vanes defines the sides of a gas transport channel that prevents mixing of gases between different channels. Typically, there will be as many different gas transport channels as there are inlet gas injectors. At the inner ends of these channels, the gas inlet port narrows into a narrow inlet slit that is slightly wider than the diameter of wafers to be processed in this processing system. This enables some local mixing of the gases before these gases reach the vicinity of the wafer. This smooths the concentration and flow profiles of the inlet gases before they reach the wafer and yet enables a nonconstant concentration and flow profile to be achieved across the wafer.

A preheat susceptor ring can be included between the inlet slit and the wafer to preheat the injected gases before they reach the wafer. This ring preferably extends completely around the wafer so that it provides a symmetric temperature environment for the wafer. In a processing system in which elevated process temperatures are produced by intense light from a light source, the susceptor is selected to be of a material that is opaque to this light. It is also advantageous for this material to have a low thermal mass so that the temperature can be rapidly changed by the light sources.

If the gas flow and concentration profiles are constant across the gas inlet port, then an increased process rate results at the perimeter of the wafer. This occurs because the reactant concentrations are depleted as they flow across the wafer to process the wafer. This is particularly easy to see for the case in which a portion of these reactant gases deposit on the wafer, but it is also true for other processes, such as etching processes in which the reactant gases are used up during that process step. Therefore, in general, it is advantageous to have a greater concentration and/or a greater flow rate for the portion of the reactant gas stream that crosses near the center of the wafer. Preferably, the wafer is rotated to produce a temporally averaged, radially symmetric processing of the wafer even though the gas flow and/or concentration is not constant across the wafer.

Although the gas flow rate and wafer rotation rate are low enough that there will generally be nonturbulent gas flow within the reactor chamber, the complicated interaction between the various parameters limits the ability to accurately determine theoretically the desired flow and concentration profiles. This is particularly true in most preferred embodiments of reactors because of the complicated interaction between heating effects, rotation of the wafer, flow rates, concentrations, backflow of gases in the rotating wafer system, temperature decomposition of the gases and complex reactions between the reactant gases and the wafer. Such theoretical analysis can be a starting point, but optimization is generally achieved empirically.

### Description of the Figures

Figure 1 is a side view of a wafer processing reactor in accordance with the present invention.

Figure 2 is a top cross-sectional view of the wafer processing reactor of Figure 1 illustrating an array of heating lamps utilized to heat the wafer.

Figure 3 is a top cross-sectional view of the wafer processing reactor of Figure 1 through a plane containing a gas inlet port and a gas exhaust port

Figure 4 is a side view of the gas supply manifold, as indicated in Figure 3.

Figure 5 is a side view cross-section of the gas inlet port, as indicated in Figure 3.

Figure 6 illustrates flow streamlines of gas from the gas inlet port to the gas outlet port

Figure 7 presents empirical plots of deposition thickness on a wafer as a function of wafer radius for several selections of gas flow rates into 7 different gas transport channels.

### Description of the Preferred Embodiment

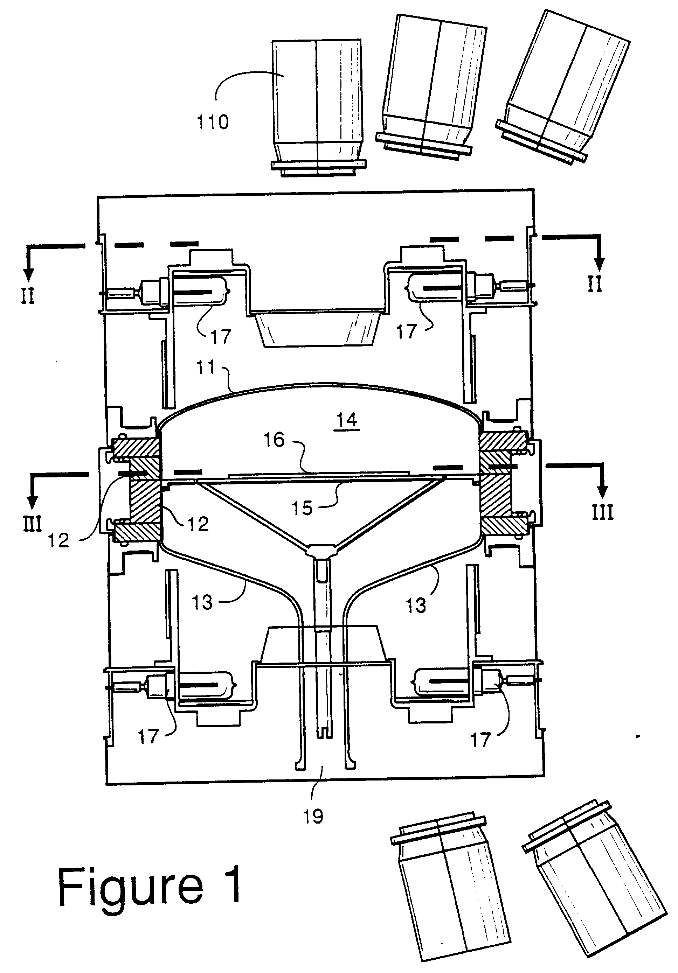

Figure 1 is a side view of a wafer processing reactor in accordance with the present invention. Walls 11-13 enclose a reaction chamber 14 in which processing of wafers takes place. A wafer pedestal 15 within this chamber can be rotated to produce axially symmetric processing of wafers by producing a time-averaged environment for a wafer 16 that is centered on the rotation axis.

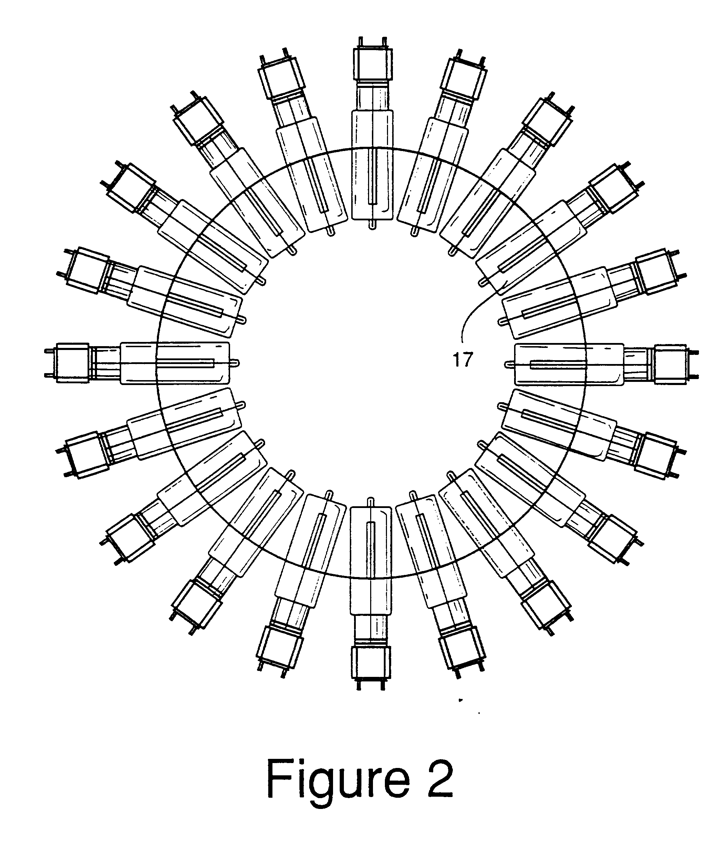

Wafer 16 is heated by means of an array of lamps 17 that are distributed in a ring centered on an axis that passes perpendicularly through wafer 16. A top cross-sectional view of these lamps is presented in Figure 2. The wafer pedestal is preferably of an opaque material that can withstand the processing temperatures so that light from lamps 17 heats the wafer even if the wafer is transparent to the light from lamps 17. In this embodiment, the pedestal is silicon carbide coated graphite.

To increase the rate at which the wafer can be thermally cycled, arrays of lamps 17 are included both above and below pedestal 15. To enable this light to reach the pedestal, walls 11 and 13 are transparent to the light from these lamps. A convenient choice of material for these walls is quartz because of its transparency, strength (to withstand pressure differences across these walls) and ability to withstand the elevated temperatures (typically 500-1,200 degrees Centigrade) utilized during wafer processing. Typical process pressures can be as low as a few 100 Pa (Torr) so that these walls need to withstand a full atmosphere of pressure. Sidewall 12 is typically a machined block of material such as quartz. In other applications, such as other CVD or etching processes, suitable choices of material include aluminum and stainless steel. Additional gases such as hydrogen or nitrogen can be injected through a gas inlet 19 into reaction chamber 14 to prevent the reactant gases from flowing into the bottom half of the process chamber. A set of infrared detectors 110 are utilized to measure the wafer temperature and provide feedback to a power source for lamps 17 to regulate the wafer temperature. A reactor of this type is illustrated in greater detail in U.S. Patent No. 5,108,792.

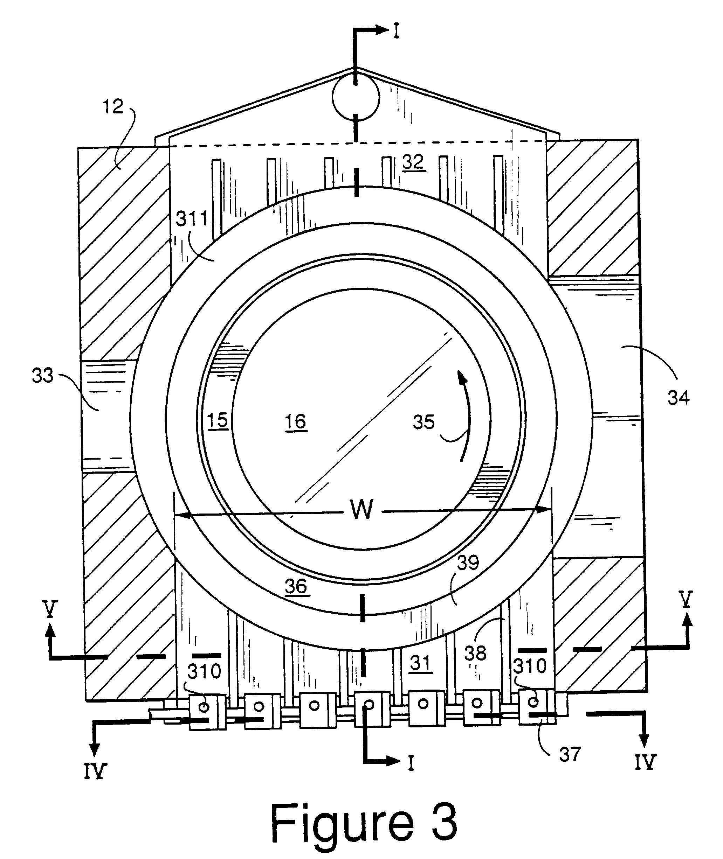

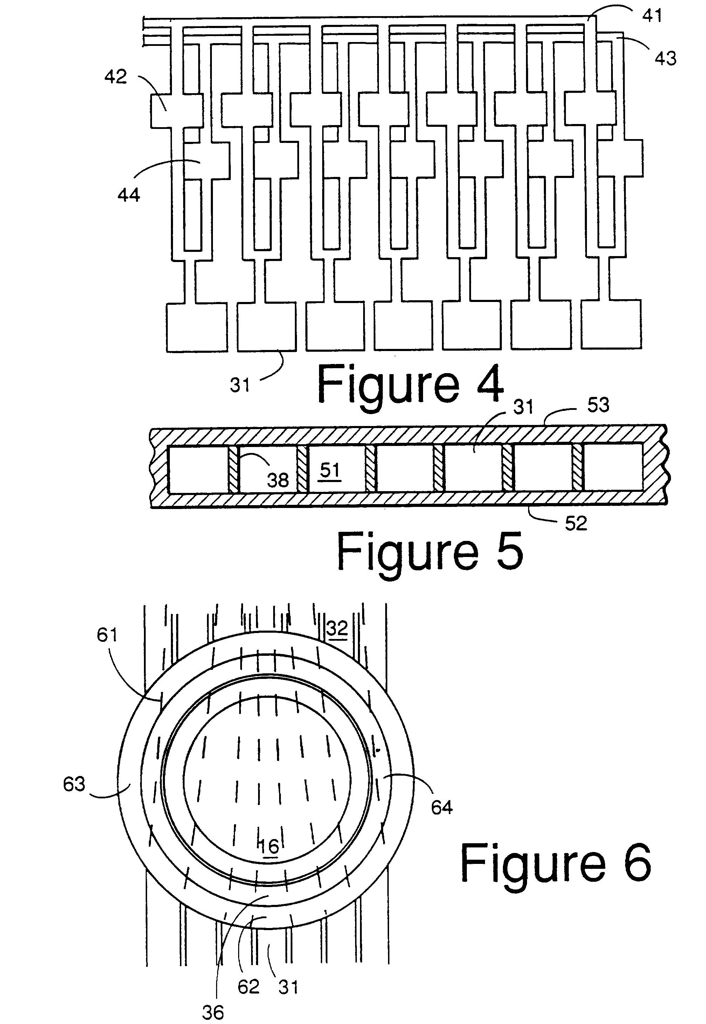

Figure 3 is a top cross-sectional view of the wafer processing reactor of Figure 1 through a plane containing a gas inlet port 31 and a gas exhaust port 32. A hole 33 is included for use by various pieces of equipment such as a thermocouple to measure the gas temperature within reaction chamber 14. A slot 34 enables wafers to be transmitted into and out of the reaction chamber. Arrow 35 illustrates that pedestal 15 and wafer 16 are rotated about an axis A that is substantially centered on the wafer and is substantially perpendicular to a top surface of the wafer. A preheat ring susceptor 36 is included to provide heating of injected gases before they reach the wafer. Although this can be achieved by a preheat susceptor that does not encircle the wafer, it is advantageous to encircle the wafer so that it experiences a more uniform processing environment. This preheat ring susceptor 36 is opaque to the light from lamps 17 and, in this embodiment, is silicon carbide coated graphite. Reactant and carrier gases are supplied into gas inlet port 31 by a gas supply manifold 37 that is illustrated in greater detail in Figure 4.

In this embodiment the gas supply manifold 37 supplies only a pair of different gases. A first of these gases is supplied from a first gas source to a first pipe 41 and a second of these gases is supplied from a second gas source to a second pipe 43. Each of these two pipes splits into seven pipes, each provided at one of a set of inlets 310 to a different channel 51 (illustrated in Figure 5 and discussed below in regard to that figure) of the gas inlet port 31. Between pipe 41 and each of the seven pipes from it to the gas inlet port channels is an associated flow controller 42. Similarly, between pipe 43 and each of the seven pipes from it to the gas inlet port channels is an associated flow controller 44. This enables the flow rate of each of these two gases to each of the seven channels to be independently controlled. The concentrations in the channels are then determined by the mix of these two gases in these channels and by the concentrations of these two gases. In other embodiments more than two pipes such as 41 and 43 can be provided to enable more control over the gas flow and concentration. For example, various carrier gases as well as multiple reactant gases can be provided. Also, fewer or greater than 7 channels can be utilized to distribute these gases.

Figure 5 is a side view cross-section of the gas inlet port 31. A set of vanes 38 extend from a bottom wall 52 to a top wall 53 of the gas inlet port and provides support for the gas inlet port These vanes also divide the gas inlet port into a set of seven channels 51 that provide the ability to prevent mixing of injected gases until a point closer to the edge of the wafer being processed. This enables greater control over the flow and concentration profiles of reactant and carrier gases across the top surface of the wafer. A typical flow profile is illustrated in Figure 6 by dashed lines 61 that indicate boundary lines between the gas flow from adjacent channels 51. This flow profile can be altered by altering the total gas flow through each of these seven channels 51. The reaction process can also be altered by changing the relative mix of gases through each of these channels.

As is illustrated in Figure 3, between the ends of the vanes 38 and the wafer is a thin slit 39 through which the reactant and carrier gases pass before entering the reactor chamber. Because the vanes do not extend into this region, the gases from adjacent channels can begin to mix, thereby smoothing out the concentration and flow profiles before these gases reach the vicinity of the wafer. This narrow slit has a width W as wide as the width of the gas inlet port 31 within the region containing the vanes. The height (i.e., the dimension of this slit perpendicular to the view of figure 3) is on the order of 3 mm so that the gases are injected into a region of small height at the wafer edge. This produces an efficient utilization of the reactant gases because this thin region will tend to flow uniformly across the reaction chamber to the exhaust port.

In general, a greater flux of reactants is required in the middle channels 62 so that a relatively higher flux results near the center of the wafer than at the perimeter. This higher flux is required in these channels because the concentration is partially depleted as it passes over the peripheral region of the wafer and on to the central portion. Furthermore, the peripheral regions of the wafer interact not only with the gas from the inner channels, but also interact within regions 63 and 64 with gases supplied through the outer channels.

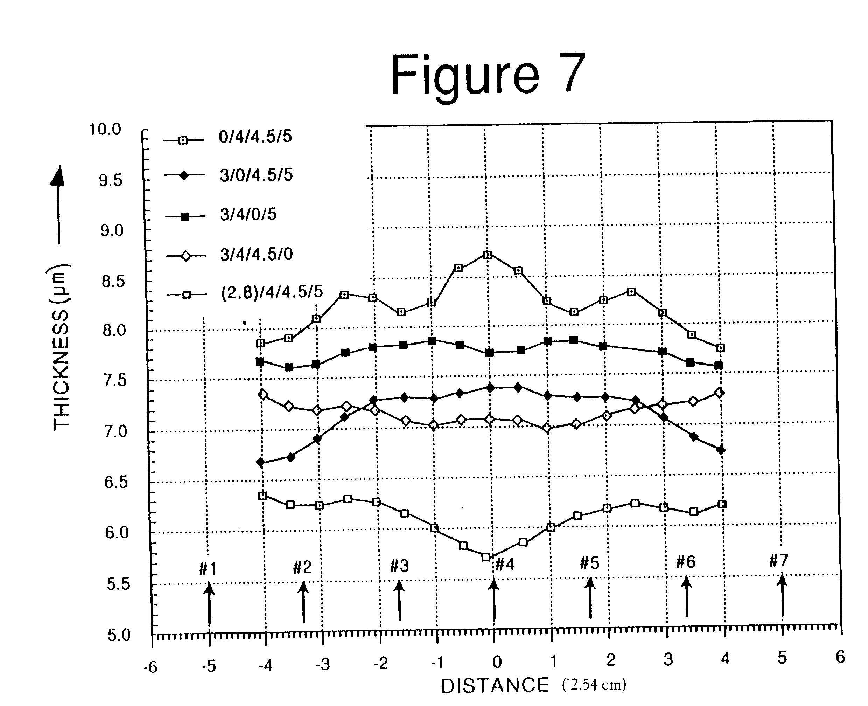

The complicated interaction between heating effects, rotation of the wafer, flow rates, concentrations, backflow of gases in the rotating wafer system, temperature, decomposition of the gases, thermal convection and complex reactions between the reactant gases and the wafer make it extremely difficult to accurately predict what combination of flow rates and concentrations will be optimal, so theoretical considerations will generally be only a starting point for the selection of the gas flow rates and concentrations through each of the channels. Because the wafer surface is heated by light from lamps 17, iocal convection cells can dominate local flow patterns. Empirical measurements will almost always be required to optimize the process. Figure 7 illustrates a typical set of such empirical data.

This figure represents the process of silicon deposition and displays the thickness (in µm), as a function of radial distance from the center of the wafer, of the resulting layer produced on the wafer. The arrowed numbers above the horizontal axis of said figure refer to the respective channel numbers. In the top left corner is indicated the total flow rate (in litres per minute) within each of the seven channels. Only four numbers are indicated since a symmetric pattern of relative flow rates is utilized in these tests. Thus, for the top curve, the first and seventh channels (i.e., the outermost channels) have zero gas flow, the second and sixth channels (i.e., the 2nd outermost channels) have a flow rate of 4, the third and fifth channels have a flow rate of 45 and the fourth channel (i.e., the central channel) has a flow rate of 5. This plot shows that the expected result that the first and seventh channels have a strong effect on the deposition over the outer regions fo the wafer. Somewhat surprisingly, the third and fourth of these curves show that the flow in the third and fifth channels has a greater effect on the thickness at the center of the wafer than does the flow rate in the central channel.

In a typical process, the total flow rate through gas inlet 19 is on the order of 8 liters per minute and the total flow rate through gas inlet port is on the order of 20-30 liters per minute. Optimal uniformity for the process of silicon deposition was achieve for relative flow rates of 11, 9, 10, 10, 10, 9, and 11 in channels 1-7, respectively. This choice produces a better uniformity than when all of these flow rates are equal. Micrometering valves and fixed orifices are utilized as flow controllers 42 and 44 to control flow rate. Other devices for controlling flow rates include mass flow controllers or other variable restrictors.

In the embodiment of figures 1-6, vanes 38 are all parallel and are directed straight ahead as can be seen in Figures 3 and 6. In alternate embodiments, the directions of these vanes can also be an adjustable process parameter. Vanes can also be placed in the slit area 39 of the inlet or the exhaust 311 to alter the flow pattern. Other variations include changes in the flow channel width W relative to the other dimensions or altering the number of flow channels used in the inlet independent of the number used in the exhaust.

## Claims

1. Wafer processing reactor comprising:
- a reaction chamber (14) for wafer processing;
- a slit-shaped gas inlet port (31) for supplying process gas across a wafer (16) located in said reaction chamber (14); and
- a gas supply manifold (37) comprising means (42, 44) connected to a plurality of spatially separated inlets (310) into said gas inlet port (31) and adjustable to different flow rates of said process gas, thereby allowing a changeable spatial gas flow distribution of said process gas through said gas inlet port (31),
**characterized** in that said gas supply manifold (37) comprises means (41, 43) for being independently supplied with at least two process gases, said adjustable means (42, 44) being provided for individual control of flow rate of each of said gases to said inlets (310).

2. Wafer processing reactor according to claim 1, wherein said slit-shaped outlet opening of said gas inlet port (31) is positioned adjacent the edge of the wafer (16) and is oriented parallel to the wafer (16).

3. Wafer processing reactor according to claim 1 or 2, wherein said adjustable means (42, 44) comprise a plurality of flow controllers (42, 44), each located in a flow path from a source of process gas to one of said inlets (310).

4. Wafer processing reactor according to claim 3, wherein said flow controllers (42, 44) are mass flow controllers, fixed orifices or micrometer valves.

5. Wafer processing reactor according to any of the claims 1 to 4,
further comprising within said gas inlet port (31):
- a plurality of vanes (38) that separate this gas inlet port (31) into a plurality of gas flow channels (51), whereby mixing of gases injected through different inlets (310) can be delayed until process gases through these different inlets reach a distal end of these vanes (38).

6. Wafer processing reactor according to claim 5, wherein at least part of said vanes (38) are parallel.

7. Wafer processing reactor according to claim 5 or 6, wherein said vanes (38) are directed toward a location in said reactor at which wafers (16) are located for processing.

8. Wafer processing reactor according to claim 5, wherein each of said vanes (38) is directed toward a point at which a wafer (16) is to be centered for processing.

9. Wafer processing reactor according to claim 7, wherein said vanes (38) are all parallel, whereby these vanes produce a flow pattern such that, when a wafer (16) is placed within said reaction chamber for processing, a flow pattern is produced that, at the wafer, is laterally symmetric across the wafer.

10. Wafer processing reactor according to any of the claims 5 to 9,
wherein a side wall portion of said reactor walls has formed therethrough a slit (39), located between a distal end of said vanes (38) and said process chamber (14), within which process gases from different channels (51) can begin to mix before reaching a location at which a wafer (16) is to be located for processing, thereby smoothing a flow rate profile of gases passing through said channels (51) before these gases reach said location at which a wafer (16) is to be located for processing.

11. Wafer processing reactor according to claim 10, further comprising:
between said slit (39) and the location at which a wafer (16) is to be processed, a preheat ring (36) for preheating gases before they reach a wafer (16).

12. Wafer processing reactor according to any of the preceding claims,
wherein said side wall portion (12) of said walls (11 - 13) includes a cylindrical section (311) that encircles a circular region within which a wafer (16) is to be located for processing and across which at least one process gas flows.

## Patentansprüche

1. Halbleiterscheiben-Behandlungsreaktor mit:
- einer Reaktionskammer (14) zur Behandlung von Halbleiterscheiben;
- einer schlitzförmigen Gaseinlaßöffnung (31) zum Zuführen von Prozeßgas über eine Halbleiterscheibe (16), die in der Reaktionskammer (14) angeordnet ist; und
- einem Gaszufuhr-Verteiler (37), der Einrichtungen (42, 44) aufweist, die mit einer Vielzahl von räumlich getrennten Einlässen (310) in der Gaseinlaßöffnung (31) verbunden und auf verschiedene Durchsätze des Prozeßgases einstellbar sind, wodurch eine veränderliche, räumliche Gasströmungsverteilung des Prozeßgases über die Gaseinlaßöffnung (31) ermöglicht wird,
dadurch **gekennzeichnet**, daß der Gaszufuhr-Verteiler (37) Einrichtungen (41, 43) aufweist, um mit mindestens zwei Prozeßgasen unabhängig versorgt zu sein, wobei die einstellbaren Einrichtungen (42, 44) zum individuellen Steuern des Durchsatzes eines jeden der Gase zu den Einlässen (310) vorgesehen sind.

2. Halbleiterscheiben-Behandlungsreaktor nach Anspruch 1,
bei dem die schlitzförmige Auslaßöffnung der Gaseinlaßöffnung (31) benachbart zur Kante der Halbleiterscheibe (16) angeordnet und parallel zu der Halbleiterscheibe (16) ausgerichtet ist.

3. Halbleiterscheiben-Behandlungsreaktor nach Anspruch 1 oder 2,
bei dem die einstellbaren Einrichtungen (42, 44) eine Vielzahl von Durchflußreglern (42, 44) aufweisen, von denen jeder in einem Strömungsweg von einer Prozeßgasquelle zu einem der Einlässe (310) angeordnet ist.

4. Halbleiterscheiben-Behandlungsreaktor nach Anspruch 3,
bei dem die Durchflußregler (42, 44) Massendurchsatzregler, stationäre Meßblenden oder Mikrometerventile sind.

5. Halbleiterscheiben-Behandlungsreaktor nach einem der Ansprüche 1 bis 4,
der ferner innerhalb der Gaseinlaßöffnung (31) aufweist:
- eine Vielzahl von Rippen (38), die diese Gaseinlaßöffnung (31) in eine Vielzahl von Gasströmungskanälen (51) teilen, wobei das Mischen der über die verschiedenen Einlässe (310) injizierten Gase verzögert werden kann, bis die Prozeßgase über diese verschiedenen Einlässe ein entferntes Ende dieser Rippen (38) erreichen.

6. Halbleiterscheiben-Behandlungsreaktor nach Anspruch 5,
bei dem mindestens ein Teil der Rippen (38) parallel ist.

7. Halbleiterscheiben-Behandlungsreaktor nach Anspruch 5 oder 6,
bei dem die Rippen (38) zu einer Stelle in dem Reaktor hin gerichtet werden, an der die Halbleiterscheiben (16) zum Behandeln angeordnet sind.

8. Halbleiterscheiben-Behandlungsreaktor nach Anspruch 5,
bei dem eine jede der Rippen (38) zu einem Punkt hin gerichtet ist, an dem eine Halbleiterscheibe (16) zum Behandeln zu zentrieren ist.

9. Halbleiterscheiben-Behandlungsreaktor nach Anspruch 7,
bei dem die Rippen (38) alle parallel sind, wobei diese Rippen ein solches Strömungsbild erzeugen, daß, wenn eine Halbleiterscheibe (16) innerhalb der Reaktionskammer zum Behandeln angeordnet ist, ein Strömungsbild erzeugt wird, das auf der Halbleiterscheibe seitensymmetrisch über die Halbleiterscheibe verläuft.

10. Halbleiterscheiben-Behandlungsreaktor nach einem der Ansprüche 5 bis 9,
bei dem ein Seitenwandteil der Reaktorwände einen durch dieses hindurch ausgebildeten Schlitz (39) aufweist, der zwischen einem entfernten Ende der Rippen (38) und der Prozeßkammer (14) angeordnet ist, innerhalb dem sich die Prozeßgase von verschiedenen Kanälen (51) zu mischen beginnen können, bevor sie eine Stelle erreichen, an der eine Halbleiterscheibe (16) zum Behandeln anzuordnen ist, wodurch ein Durchsatzströmungsprofil von über die Kanäle (51) strömenden Gasen geglättet wird, bevor diese Gase die Stelle erreichen, an der eine Halbleiterscheibe (16) zum Behandeln anzuordnen ist.

11. Halbleiterscheiben-Behandlungsreaktor nach Anspruch 10, ferner aufweisend:
einen Vorheizring (36) , der zwischen dem Schlitz (39) und der Stelle, an der eine Halbleiterscheibe (16) zu behandeln ist, angeordnet ist und der die Gase, bevor sie eine Halbleiterscheibe (16) erreichen, vorheizt.

12. Halbleiterscheiben-Behandlungsreaktor nach einem der vorhergehenden Ansprüche,
bei dem das Seitenwandteil (12) der Wände (11-13) einen zylindrischen Abschnitt (311) einschließt, der einen kreisförmigen Bereich umgibt, innerhalb dem eine Halbleiterscheibe (16) zum Behandeln anzuordnen ist und durch den mindestens ein Prozeßgas strömt.

## Revendications

1. Réacteur pour le traitement de plaquettes comprenant :
- une chambre de réaction (14) pour le traitement des plaquettes ;
- un orifice d'admission du gaz en forme de fente (31) destiné à fournir du gaz de traitement à travers une plaquette (16) placée dans ladite chambre de réaction (14) ; et
- un collecteur d'alimentation en gaz (37) comprenant des moyens (42, 44) reliés à plusieurs entrées séparées dans l'espace (310) dans ledit orifice d'admission du gaz (31) et réglables selon différentes allures d'écoulement dudit gaz de traitement, permettant de ce fait une distribution de l'écoulement du gaz spatiale changeable dudit gaz de traitement à travers ledit orifice d'admission du gaz (31), caractérisé en ce que
ledit collecteur d'alimentation en gaz (37) comprend des moyens (41, 43) destinés à être alimentés de manière indépendante avec au moins deux gaz de traitement, lesdits moyens réglables (42, 44) étant destinés à commander de manière individuelle l'allure d'écoulement de chacun desdits gaz vers lesdites entrées (310).

2. Réacteur pour le traitement de plaquettes selon la revendication 1, dans lequel ladite ouverture de sortie en forme de fente dudit orifice d'admission du gaz (31) est placée à côté de l'arête de la plaquette (16) et est orientée parallèlement à la plaquette (16).

3. Réacteur pour le traitement de plaquettes selon la revendication 1 ou 2, dans lequel lesdits moyens réglables (42, 44) comprennent plusieurs dispositifs de commande de l'écoulement (42, 44) placés chacun dans une trajectoire d'écoulement d'une source de gaz de traitement vers l'une desdites entrées (310).

4. Réacteur pour le traitement de plaquettes selon la revendication 3, dans lequel lesdits dispositifs de commande de l'écoulement (42, 44) sont des dispositifs de commande du flux massique, des orifices fixes ou des soupapes micrométriques.

5. Réacteur pour le traitement de plaquettes selon l'une des revendications 1 à 4, comprenant également à l'intérieur dudit orifice d'admission du gaz (31) :
- plusieurs soupapes (38) qui séparent ledit orifice d'admission du gaz (31) en plusieurs canaux d'écoulement du gaz (51), le mélange des gaz injectés à travers différentes entrées (310) pouvant de ce fait être délayé jusqu'à ce que les gaz de traitement à travers lesdites entrées différentes atteignent une extrémité distale de ces soupapes (38).

6. Réacteur pour le traitement de plaquettes selon la revendication 5, dans lequel au moins une partie de ces soupapes sont parallèles.

7. Réacteur pour le traitement de plaquettes selon la revendication 5 ou 6, dans lequel lesdites soupapes (38) sont dirigées vers un point dans ledit réacteur où les plaquettes (16) sont placées pour être traitées.

8. Réacteur pour le traitement de plaquettes selon la revendication 5, dans lequel chacune desdites soupapes (38) est dirigée vers un point où une plaquette (16) doit être centrée pour être traitée.

9. Réacteur pour le traitement de plaquettes selon la revendication 7, dans lequel lesdites soupapes (38) sont toutes parallèles, ces soupapes produisant de ce fait un schéma d'écoulement tel que, lorsqu'une plaquette (16) est placée à l'intérieur de ladite chambre de réaction pour être traitée, un schéma d'écoulement est produit qui, au niveau de la plaquette, est latéralement symétrique par-dessus la plaquette.

10. Réacteur pour le traitement de plaquettes selon l'une des revendications 5 à 9, dans lequel une portion de paroi latérale desdites parois du réacteur présente une fente (39) placée entre une extrémité distale desdites soupapes (38) et ladite chambre de traitement (14), à l'intérieur de laquelle les gaz de traitement provenant de différents canaux (51) peuvent commencer à se mélanger avant d'atteindre le point où la plaquette (16) doit être placée pour être traitée, aplanissant un profil d'allure d'écoulement des gaz passant à travers lesdits canaux (51) avant que ces gaz n'atteignent ledit point où une plaquette (16) doit être placée pour être traitée.

11. Réacteur pour le traitement de plaquettes selon la revendication 10, comprenant également :
entre ladite fente (39) et le point où une plaquette (16) doit être traitée, un anneau de préchauffage (36) destiné à préchauffer les gaz avant qu'ils n'atteignent la plaquette (16).

12. Réacteur pour le traitement de plaquettes selon l'une des revendications précédentes, dans lequel ladite portion de paroi latérale (12) desdites parois (11-13) inclut une section cylindrique (311) qui entoure une zone circulaire à l'intérieur de laquelle une plaquette (16) doit être placée pour être traitée et à travers laquelle au moins un gaz de traitement s'écoule.
